# EUROPÄISCHE PATENTSCHRIFT

(11) **EP 1 025 435 B1**
(45) Veröffentlichungstag und Bekanntmachung des Hinweises auf die Patenterteilung: **02.05.2007**
(21) Anmeldenummer: 98955478.7
(22) Anmeldetag: 19.10.1998
(51) Int. Cl.: G01N 27/82

(54) **VERFAHREN ZUR ERMITTLUNG VON DEFEKTEN IN WERKSTÜCKEN SOWIE ANLAGE UND MAGNETFELDMESSGERÄT ZUR DURCHFÜHRUNG DIESES VERFAHRENS**
METHOD FOR DETECTING DEFECTS IN WORK PIECES AND FACILITY AND MAGNETIC FIELD MEASURING APPARATUS FOR IMPLEMENTING SAID METHOD
PROCEDE DE DETERMINATION DE DEFAUTS DANS DES PIECES, ET INSTALLATION ET APPAREIL DE MESURE DE CHAMP MAGNETIQUE POUR LA MISE EN OEUVRE DUDIT PROCEDE

(30) Priorität: 20.10.1997 DE 19746000
(43) Veröffentlichungstag der Anmeldung: 09.08.2000
(73) Patentinhaber: Rolls-Royce Deutschland Ltd & Co KG, 15827 Blankenfelde-Mahlow (DE)
(72) Erfinder: TAVRIN, Yuri, D-52428 Jülich (DE); SIEGEL, Michael, D-52355 Düren (DE); PLATH, Armin, D-14612 Falkensee (DE); SCHREIBER, Karl, D-15806 Mellensee (DE)
(86) Internationale Anmeldenummer: PCT/EP1998/006600
(87) Internationale Veröffentlichungsnummer: WO 1999/021000

(56) Entgegenhaltungen:
- EP-A- 0 308 888
- US-A- 4 864 233
- US-A- 5 006 800

## Beschreibung

Die Erfindung betrifft ein Verfahren zur Ermittlung von ferromagnetischen Verunreinigungen in Werkstücken aus unmagnetischem Material durch Magnetisierung der Verunreinigungen und Messung des magnetischen Signals der Verunreinigungen mittels eines Magnetfeldmeßgerätes. Sie betrifft des weiteren ein Magnetfeldmeßgerät zur Durchführung des Verfahrens.

Im Maschinenbau werden immer häufiger Werkstücke - unter diesen Begriff fallen auch Bauteile - aus unmagnetischem Material, insbesondere aus Nickel- oder Titanbasiswerkstoffen, hergestellt, damit die Werkstücke hohen mechanischen und/oder thermischen Belastungen standhalten können. Dies gilt vor allem für Bauteile von Flug-Gasturbinen, da die hierfür verwendeten Materialien zusätzlich ein möglichst geringes spezifisches Gewicht aufweisen sollen.

Im Vordergrund stehen hier insbesondere Nickel- und Titanbasislegierungen. Im Verlauf des metallurgischen Herstellungsprozesses können eisenhaltige Verunreinigungen in die Legierung gelangen. Diese Verunreinigungen führen zu Störungen in der Mikrostruktur des Werkstoffs und beeinträchtigen somit die mechanische Belastbarkeit des Werkstücks. Sie werden deshalb auch als Defekte, aufgrund ihrer Eisenhaltigkeit als ferromagnetische Defekte, bezeichnet. Je nach Größe und Anzahl der Verunreinigungen und je nach ihrer räumlichen Lage im Werkstück kann es bei einer bestimmten mechanischen Belastung desselben zur Zerstörung des Werkstücks kommen. Da ferromagnetische Verunreinigungen in einer Nickel- oder Titanbasislegierung immer enthalten sein können, wird für jede konkrete Anwendung und die damit verbundene Belastung eine bestimmte zulässige Masse, d. h. Größe der Verunreinigungen und ihre räumliche Lage im Werkstück festgelegt. Diese maximal zulässige Masse der Verunreinigungen wird als kritische Masse bezeichnet.

Besonders kritisch im Hinblick auf die genannten Verunreinigungen sind Bauteile oder Werkstücke von Flug-Gasturbinen, da hierbei die Standfestigkeitsanforderungen besonders hoch sind. Daher gilt es, bereits bei der Herstellung der entsprechenden Werkstücke - hierbei handelt es sich insbesondere um die die Rotorschaufeln tragenden Laufradscheiben oder auch Wellen einer Flug-Gasturbine - die Masse der ferromagnetischen Verunreinigungen in diesem Werkstück bzw. einem Rohling desselben zu ermitteln, ehe dieses Werkstück weiterbearbeitet und insbesondere in die Flug-Gasturbine eingebaut wird. Letzteres soll nämlich nur dann erfolgen, wenn die festgestellte Masse der tatsächlich vorhandenen Verunreinigungen geringer ist als die oben genannte kritische Masse von derartigen Verunreinigungen.

Grundsätzlich wären drei Verfahren zur Ermittlung von ferromagnetischen Verunreinigungen einsetzbar, nämlich die Röntgentomographie, die Ultraschallmessung und die Magnetoskopmessung.

Mittels Röntgentomographie können Verunreinigungen aufgrund ihrer unterschiedlichen Zusammensetzung und des damit verbundenen Röntgenkontrasts nachgewiesen werden. Die Röntgentomographie ist allerdings extrem zeitaufwendig, sehr teuer und scheidet deshalb als Routineverfahren für Produktionsprozesse aus. Die Methode wird allenfalls zu Vergleichsmessungen und zur Kalibrierung anderer Verfahren benutzt.

Eine Ultraschallmessung erfaßt Verunreinigungen aufgrund ihrer unterschiedlichen Dichte. Durch die Streuung des Ultraschalls an den Kristalliten der Basislegierung wird der Kontrast jedoch erheblich verringert. Die Methode ist deshalb nur für größere Verunreinigungen in nicht sehr dicken Werkstücken einsetzbar.

Das - gattungsgemäße - Magnetoskopmeßverfahren nutzt den Umstand, daß die vorbeschriebenen Verunreinigungen ferromagnetisch sind. Bei dem Verfahren wird eine Magnetfeldmeßeinrichtung mit einem Magnetfeldfühler benutzt, der einen Magneten enthält, über den die Verunreinigungen magnetisiert werden. Simultan erfolgt die Messung des magnetischen Signals der magnetisierten Verunreinigungen.

Das Magnetoskopmeßverfahren hat jedoch eine Reihe von Nachteilen. Da jeweils nur im Meßbereich magnetisiert wird, werden die Verunreinigungen nach ihrer Tiefenlage im Werkstück unterschiedlich magnetisiert. Da die magnetische Induktion der Magnetisierungseinrichtung mit der dritten Potenz des Abstands abnimmt, werden die Verunreinigungen mit einem größeren Abstand zum Magnetfeldfühler nur extrem schwach magnetisiert und somit von diesem nicht erfaßt. Desweiteren ist das Magnetfeld aufgrund seiner nur punktuellen Einwirkung inhomogen, was zur Folge hat, daß das magnetische Signal der Verunreinigungen je nach deren Anordnung in Bezug auf die Magnetisierungseinrichtung unterschiedlich ausgerichtet sind. Aufgrund des undefinierten Magnetisierungszustands kann deshalb kein Rückschluß auf die Masse der Verunreinigung und deren Tiefe im Werkstück getroffen werden.

In der DE 39 23 377 C1 ist ein Verfahren zur Ermittlung der Lage einer Bruchstelle in einem Spannstahl innerhalb eines Spannbetonteils beschrieben. Durch Magnetisierung dieses Bauteils entsteht an der Bruchstelle eine typische Dipolbildung, die durch ein Magnetfeldmeßgerät erfaßt kann.

Der Erfindung liegt die Aufgabe zugrunde, ein für die Serienfertigung geeignetes Verfahren bereitzustellen, das dazu geeignet ist, ferromagnetische Verunreinigungen in unmagnetischen Werkstücken genau zu orten und auch deren Masse zu erfassen. Eine weitere Aufgabe besteht darin, eine dazugehörende Magnetfeldmeßeinrichtung zur Durchführung dieses Verfahrens zu konzipieren.

Soweit es das Verfahren angeht, wird die Aufgabe erfindungsgemäß durch folgende Verfahrensschritte gelöst:
a) Das Werkstück wir zumindest abschnittsweise im wesentlichen gleichmäßig über das Volumen einem Magnetfeld ausgesetzt;
b) das Werkstück wird erst dann dem Magnetfeldmeßgerät zugeführt und dort das magnetische Signal der jeweiligen Verunreinigung erfaßt;
c) die Tiefe der jeweiligen Verunreinigung im Werkstück wird durch folgende Maßnahmen festgestellt:
   aa) Erfassen des Signals der Verunreinigung in einem ersten Abstand zwischen Magnetfeldfühler und der Oberfläche des Werkstücks;
   bb) Erfassen des Signals der Verunreinigung in einem zweiten Abstand zwischen Magnetfeldfühler und der Oberfläche des Werkstücks;
   cc) Bildung eines Signalverhältnisses als Quotient der Meßsignale aus den beiden erfaßten Signalen der Verunreinigung,
   dd) Feststellung der Tiefe anhand einer Kurve, die die Abhängigkeit zwischen Signalverhältnis und Tiefe darstellt.

Grundgedanke der Erfindung ist es, das Werkstück bzw. die Verunreinigungen vor der eigentlichen Messung mittels eines Magnetisierungsprozesses in einen magnetisch geordneten und damit definierten Zustand zu bringen und erst danach mit Hilfe des Magnetfeldmeßgeräts das jeweilige magnetische Signal einer Verunreinigung zu erfassen, beispielsweise durch eine geeignete Rasterung, d. h. Relativbewegung zwischen Magnetfeldfühler und Werkstück. Damit sind die voraussetzungen geschaffen, um eine bestimmte verunreinigung nicht nur hinsichtlich seiner Lage, sondern auch bezüglich seiner Masse relativ genau erfassen zu können.

Ausgehend von der ersten Abtastebene erfolgt die Tiefenmessung durch zwei Meßvorgänge in unterschiedlichem Abstand zur Oberfläche des Werkstücks durch Bildung eines Signalverhältnisses und durch anschließenden Abgriff anhand einer die Abhängigkeit zwischen Signalverhältnis und Tiefe darstellenden Kurve. Dabei ist der Begriff "Kurve" hier in allgemeinster Form zu verstehen. Sie kann beispielsweise als Grafik, aber auch in Form einer Matrix oder einer Funktion vorliegen. Es versteht sich, daß sie zuvor durch entsprechende Kalibrierung ermittelt und festgelegt worden ist. Es hat sich herausgestellt, daß sich mit dieser Methode auf einfache Weise und ohne großen apparativen Aufwand eine relativ genaue Aussage über die Tiefenanordnung der jeweils betrachteten Verunreinigung treffen läßt.

Erstrebenswert ist es, die Verunreinigungen bis zur Sättigung durchzumagnetisieren. In den meisten Anwendungsfällen reicht jedoch eine Magnetisierung, bei der nicht bis zur Sättigungsgrenze gegangen wird, aus, damit die Verunreinigungen ein magnetisches Signal erzeugen. Auf jeden Fall ist es zweckmäßig, daß das Werkstück einem weitgehend homogenen Magnetfeld ausgesetzt wird. Sofern das Werkstück zu einem früheren Zeitpunkt stärkeren Magnetfeldern als die Magnetisierungsfeldstärke ausgesetzt war, sollte vor der Magnetisierung eine Entmagnetisierung erfolgen.

In weiterer Ausgestaltung der Erfindung ist vorgesehen, daß das Werkstück in einer Abtastebene mit dem Magnetfeldmeßgerät abgetastet und auf diese weise die Lage der Verunreinigungen in Bezug auf diese Ebene festgestellt wird.

Steht erst einmal die Tiefe der Verunreinigung fest, läßt sich auch die Masse der Verunreinigung ermitteln. Hierfür werden nach der Erfindung folgende alternativen Vorschläge gemacht.

Bei dem einen Vorschlag wird eine Kurve aus einer Kurvenschar ausgewählt, die den Zusammenhang zwischen Masse und Meßsignal bei verschiedenen Tiefen darstellt, und es wird dann die Masse anhand des Meßsignals und der ausgewählten Kurve festgestellt. Auch hier ist Voraussetzung, daß die Kurvenschar zuvor festgelegt wird. Nach Auswahl der Kurve ist der Abgriff der Masse unter Zuhilfenahme des Meßsignals direkt möglich.

Alternativ dazu kann die Masse der Verunreinigung auch dadurch festgestellt werden, daß eine Kurvenschar erstellt wird, die den Zusammenhang zwischen der Tiefe der Verunreinigung und dessen Meßsignal bei verschiedenen Massen darstellt. Anhand des Meßsignals und der festgestellten Tiefe kann die Kurve bestimmt werden, die die jeweilige Masse der Verunreinigung repräsentiert.

Das Magnetfeldmeßgerät selbst ist erfindungsgemäß durch folgende Merkmale gekennzeichnet:
a) der Magnetfeldfühler ist in einer Abtastebene bewegbar;
b) der Magnetfeldfühler ist senkrecht zur Abtastebene zwischen zwei Meßpositionen bewegbar;
c) das Magnetfeldmeßgerät weist eine Einrichtung zur Errechnung des Signalverhältnisses der Meßsignale an den beiden Meßpunkten auf;
d) in dem Magnetfeldmeßgerät ist eine Kurve gespeichert, die die Abhängigkeit zwischen dem Signalverhältnis und der Tiefe der Verunreinigung im Werkstück darstellt;
e) das Magnetfeldmeßgerät weist eine Einrichtung zur Errechnung der Tiefe einer Verunreinigung anhand des festgestellten Signalverhältnisses und der Kurve auf.

Mit einem solchen Magnetfeldmeßgerät läßt sich eine bestimmte Verunreinigung relativ genau orten, und zwar zum einen durch Rasterung in der Abtastebene und zum anderen durch Erfassung des magnetischen Signals in zwei unterschiedlichen Abständen zur Abtastebene, wobei die Abtastebene zweckmäßigerweise parallel zu einer der Oberflächen des Werkstücks liegen sollte. Wie schon oben erwähnt, kann die Speicherung der Kurve in dem Magnetfeldmeßgerät auf verschiedenste Weise erfolgen. Wichtig ist nur, daß sie in den Rechenprozeß eingebunden werden kann, an dessen Ende ein der Tiefe der Verunreinigung entsprechendes Signal steht, das dann vorzugsweise digital angezeigt wird.

Für die zusätzliche Ermittlung der Masse einer bestimmten Verunreinigung stehen nach der Erfindung zwei Ausführungsformen zur Verfügung. Die eine ist durch folgende Merkmale gekennzeichnet:
a) in dem Magnetfeldmeßgerät ist eine Kurvenschar von Kurven für verschiedene Tiefen gespeichert, die die Abhängigkeit zwischen Masse und Meßsignal bei verschiedenen Tiefen darstellen;
b) das Magnetfeldmeßgerät weist eine Einrichtung zur Errechnung der Masse der Verunreinigung anhand der Kurvenschar durch Auswahl der der festgestellten Tiefe entsprechenden Kurve und anhand des Meßsignals auf.

Alternativ dazu ist folgende Ausführungsform vorgesehen:
a) in dem Magnetfeldmeßgerät ist eine Kurvenschar von Kurven für verschiedene Massen gespeichert, die die Abhängigkeit zwischen Tiefe und Meßsignal bei verschiedenen Massen darstellen;
b) das Magnetfeldmeßgerät weist eine Einrichtung zur Errechnung der Masse der Verunreinigung anhand des Meßsignals und der festgestellten Tiefe auf.

Beide Alternativen stellen Möglichkeiten dar, über einen Rechenprozeß neben der Tiefe der Verunreinigung auch dessen Masse zu bestimmen.

Als Magnetfeldmeßgerät kommen grundsätzlich alle bekannten Geräte zur Erfassung von Magnetfelder in Frage. Eine besonders gute Auflösung läßt sich mit Hilfe eines Gradiometers 2. Ordnung mit supraleitenden Quanten-Interferometern (SQUID) auf der Basis von Hochtemperatur-Supraleitern erzielen. Solche Magnetfeldmeßgeräte sind im Stand der Technik an sich bekannt (Tavrin, Chang, Wolf und Braginski, A second-order SQUID-gradiometer operating at 77K, Supercond. Sci. Technol. 7 (1994), S. 265 bis 268; Jenks, Sadeghi und Wikswo, SQUIDs for nondestructive evaluation, Appl. Phys. 30 (1997) S. 293 bis 323). Sie können auch Verunreinigungen bis in eine Tiefe von 50 mm hinsichtlich ihrer Anordnung und Masse genau erfassen, und sie eignen sich auch für Routineverfahren bei der Produktion solcher Werkstücke.

In der Zeichnung ist die Erfindung anhand eines Ausführungsbeispiels näher veranschaulicht. Es zeigen:
- Figur 1: die Seitenansicht eines scheibenförmigen Werkstücks mit einem Magnetfeldfühler in einer ersten Meßposition;
- Figur 2: die Darstellung gemäß Figur 1 mit dem Magnetfeldfühler in einer zweiten Meßposition;
- Figur 3: eine Grafik zur Darstellung des Zusammenhangs zwischen dem Signalverhältnis der Meßsignale aus den beiden Meßpositionen über der Tiefe einer Verunreinigung im Werkstück;
- Figur 4: eine Grafik mit der Darstellung des Zusammenhangs zwischen einem Meßsignal über der Masse einer Verunreinigung im Werkstück bei verschiedenen Tiefen;
- Figur 5: eine Grafik zur Darstellung des Zusammenhangs zwischen einem Meßsignal über der Tiefe einer Verunreinigung im Werkstück bei verschiedenen Massen.

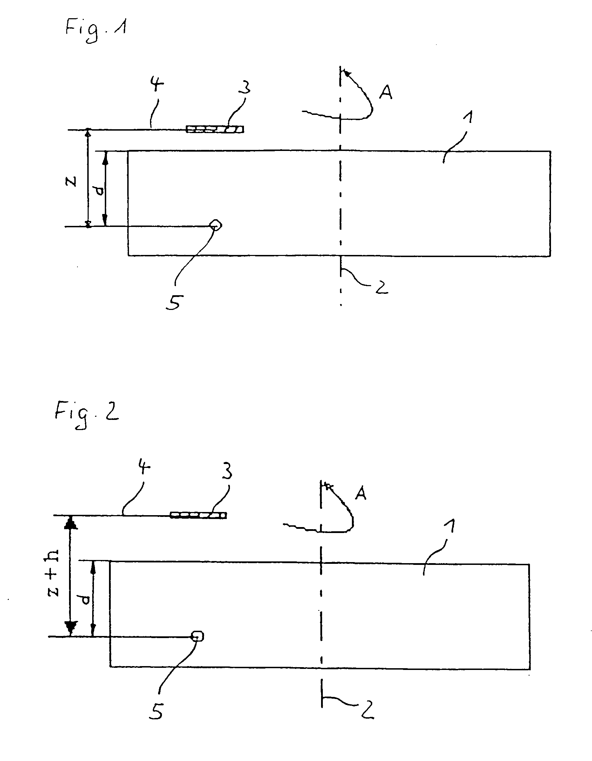

Die Figuren 1 und 2 zeigen in vereinfachter Darstellung ein scheibenförmiges, rotationssymmetrisches Werkstück 1, das um die Achse 2 drehbar in einer hier nicht näher dargestellten Werkstückaufnahme gelagert ist. Die Drehrichtung ist durch den Pfeil A angezeigt.

Oberhalb des Werkstücks 1 ist ein Magnetfeldfühler 3 zu sehen. Er ist Teil eines hier nicht näher dargestellten Magnetfeldmeßgeräts in Form eines Gradiometers 2. Ordnung mit supraleitenden Quanten-Interferometern (SQUID) auf der Basis von Hochtemperatur-Supraleitern. Der Magnetfeldfühler 3 ist separat oder als Teil des Magnetfeldmeßgeräts in einer horizontalen Abtastebene 4 bewegbar, wobei es angesichts der Rotationssymmetrie des Werkstücks 1 und dessen drehbarer Lagerung ausreicht, wenn er in radialer Richtung, d. h. in der Zeichnungsebene horizontal verfahrbar ist, um dessen gesamte Oberfläche abtasten zu können. Die hierfür erforderlichen apparativen Einrichtungen sind der Übersichtlichkeit halber weggelassen.

In dem Werkstück 1 ist - überdimensional vergrößert - eine ferromagnetische Verunreinigung 5 vorhanden, und zwar mit dem vertikalen Abstand z zu der Abtastebene 4 und damit zu dem Magnetfeldfühler 3. Dieser ist beim Abtasten genau oberhalb der Verunreinigung 5 angehalten worden, wobei dessen Lage in der Horizontalebene durch den oben beschriebenen Abtastvorgang in der Abtastebene ermittelt worden ist, und zwar durch Erfassung des von ihm ausgehenden maximalen magnetischen Signals.

Zuvor war das Werkstück 1 in einer hier nicht gezeigten, separaten Magnetisierungseinrichtung über sein gesamtes Volumen einem homogenen Magnetfeld ausgesetzt worden, so daß die in ihm enthaltenen ferromagnetischen Verunreinigungen einen definierten gleichmäßigen Magnetisierungszustand erhalten haben.

Nach Festlegung des Werkstücks 1 und des Magnetfeldfühlers 3 in der gezeigten ersten Meßposition wird ein erster Meßvorgang gestartet. Aufgrund des von der Verunreinigung 5 ausgehenden magnetischen Signals wird ein erstes Meßsignal ermittelt. Danach wird der Magnetfeldfühler 3 um einen Betrag h senkrecht zur Oberfläche des Werkstücks 1 nach oben in eine zweite Meßpositon bewegt, wie aus Figur 2 ersichtlich ist. Der Magnetfeldfühler 3 hat jetzt einen Abstand z+h zu der Verunreinigung 5. Durch einen erneuten Meßvorgang wird ein zweites Meßsignal erhalten, das aufgrund der größeren Entfernung zu der Verunreinigung 5 schwächer ist als das erste. Es versteht sich, daß bei der Ausmessung anderer Verunreinigungen die Differenz h zwischen den beiden Meßpositionen immer gleich ist.

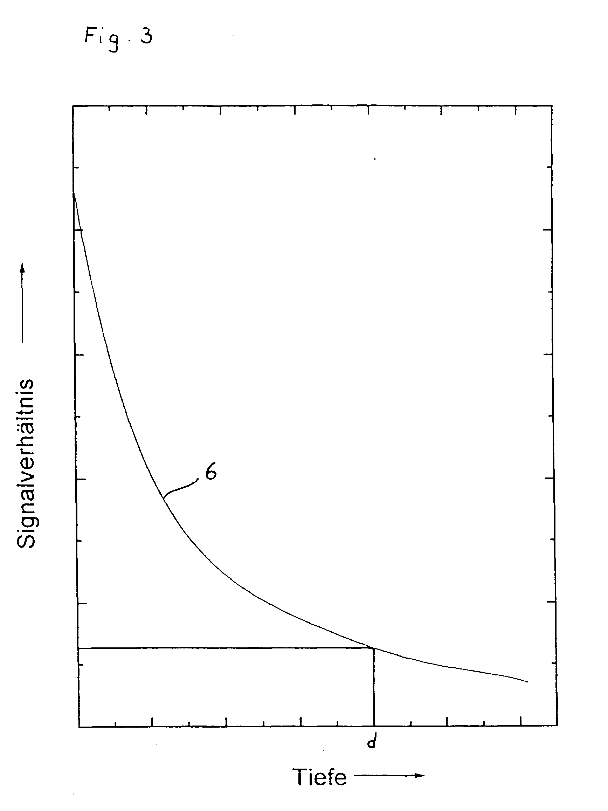

Für die Bestimmung der Tiefe d der Verunreinigung 5 - gerechnet von der obenseitigen Oberfläche des Werkstücks 1 - wird zunächst ein Signalverhältnis als Quotient aus den beiden Meßsignalen in der ersten und in der zweiten Meß-position gebildet. Mit Hilfe der Grafik gemäß Figur 3 ist dann die Bestimmung der Tiefe möglich, wobei die Grafik auf der Abszisse das Signalverhältnis und auf der Ordinate die Tiefe angibt. Die zugehörigen Pfeile geben - wie auch in den übrigen Grafiken - die Richtungen mit Werten zunehmender Größe an. In die Grafik ist eine Kurve 6 eingezeichnet, aus der sich der Zusammenhang zwischen dem Signalverhältnis und der Tiefe der Verunreinigung 5 im Werkstück 1 ergibt. Es ist zu erkennen, daß das Signalverhältnis umso geringer ist, je größer die Tiefe ist. Aufgrund des ermittelten Signalverhältnisses ergibt sich anhand der Kurve 6 die Tiefe d.

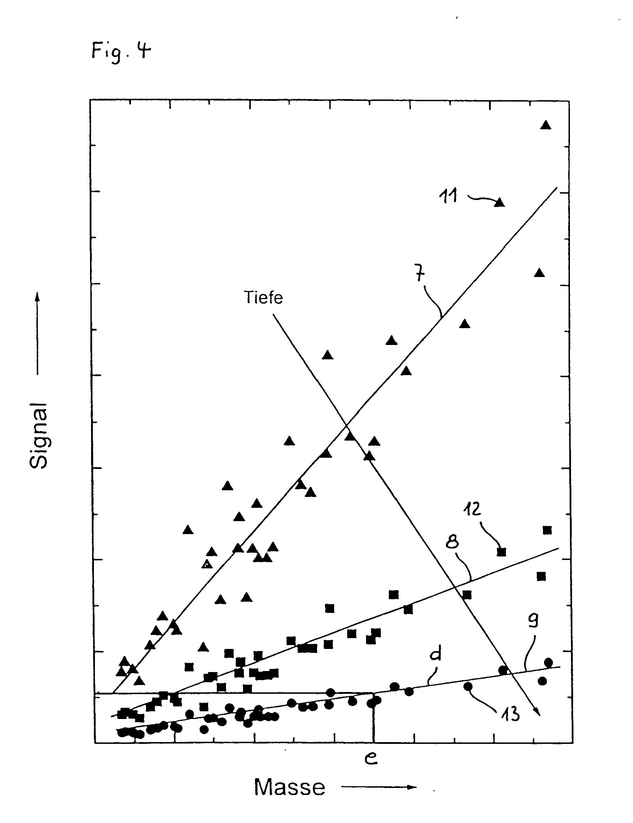

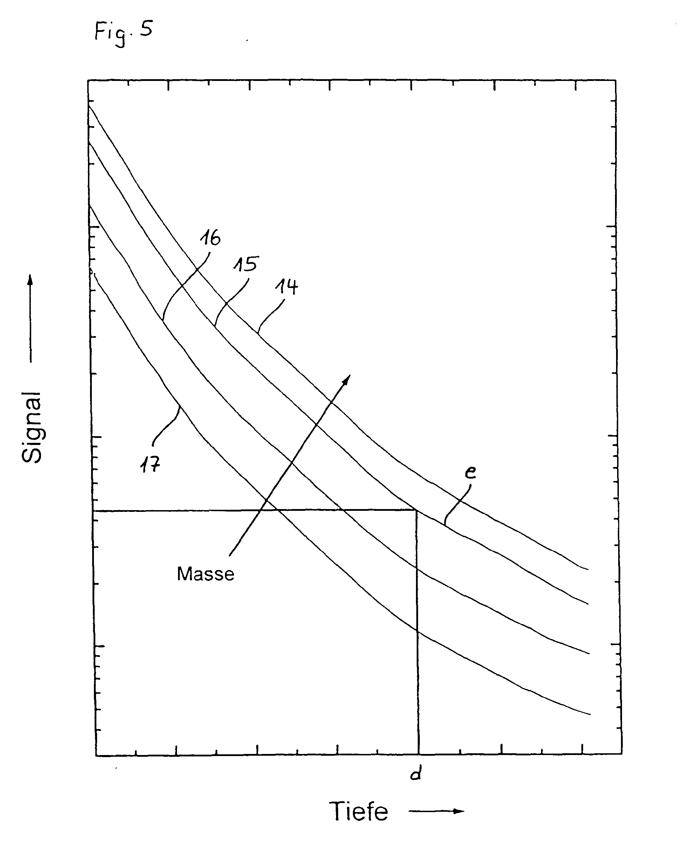

Die Ermittlung der Masse der Verunreinigung 5 kann alternativ mit der Grafik gemäß Figur 4 oder der gemäß Figur 5 erfolgen. Zunächst sei die Methode mit der Grafik gemäß Figur 4 erläutert.

In dieser Grafik bezeichnet die Abszisse das Meßsignal in der ersten Meßposition und die Ordinate die Masse. Da zwischen Meßsignal und Masse kein direkter Zusammenhang besteht - das Meßsignal ist nicht nur von der Masse der Verunreinigung 5, sondern auch von dessen Tiefe d im Werkstück abhängig - ist in die Grafik eine Kurvenschar eingezeichnet, und zwar beispielhaft bestehend aus drei Geraden 7, 8, 9. Die Geraden 7, 8, 9 sind jeweils mit Verunreinigungen verschiedener Masse bei gleicher Tiefenanordnung meßtechnisch ermittelt worden. Die Gerade 7 mit der steilsten Steigung stellt eine Mittelung der durch die Dreiecke - beispielhaft mit 11 bezeichnet - symbolisierten Meßwerte dar, wobei die hierfür herangezogenen Verunreinigungen eine geringe Tiefe hatten. Entsprechend stellt die mittlere Gerade 8 eine Mittelung der durch die Quadrate 12 gekennzeichneten Meßwerte dar, die mit Verunreinigungen verschiedener Massen in einer mittleren Ebene erfaßt worden sind. Die untere Gerade 9 repräsentiert die Tiefe d. Hier sind die Meßwerte durch Punkte - beispielhaft mit 13 bezeichnet - gekennzeichnet. Die Tiefe der Verunreinigungen zur Ermittlung der Geraden 9 war hier noch größer als bei der Geraden 8.

Mit Hilfe der Grafik gemäß Figur 4 läßt sich die Masse e der Verunreinigung 5 durch Abgriff desjenigen Punkts auf der Geraden 10 ermitteln, der auf der Höhe des Meßsignals in der ersten Meßposition liegt. Hierdurch ergibt sich der Wert e für die Masse.

Bei der Grafik gemäß Figur 5 ist das Meßsignal über der Tiefe aufgetragen. Hierzu existiert eine Kurvenschar, die die Masse mit in Richtung des Pfeils aufsteigenden Werten repräsentiert. In der Grafik sind beispielhaft vier Kurven 14, 15, 16, 17 eingezeichnet. Das Meßsignal ist logarithmisch aufgetragen.

Jede Kurve repräsentiert den Zusammenhang zwischen Meßsignal und Tiefe bei konstanter Masse. Da die Tiefe durch die Ermittlung mit Hilfe der Grafik gemäß Figur 3 ebenso bekannt ist wie das Meßsignal in der ersten Meßposition, kann die jeweilige Kurve 14, 15, 16, 17 durch Abgriff von der Abszisse und der Ordinate ermittelt werden. Im vorliegenden Beispiel ergibt sich hierdurch die Kurve 15 als die die Masse e repräsentierende Kurve.

Es versteht sich, daß die vorbeschriebene Art der Ermittlung von Tiefe d der Verunreinigung 5 und dessen Masse e lediglich dem Verständnis der Erfindung dienen soll. Bei der apparativen Ausbildung des Magnetfeldmeßgeräts sind die oben beschriebenen Zusammenhänge beispielsweise in einem Mikroprozessor nach Durchführung einer Kalibrierung gespeichert, wobei die Ausrechnung der Tiefe und der Masse mit Hilfe eines Rechnerprogramms auf der Basis der gespeicherten Zusammenhänge erfolgt. Dabei können die Kurven 6, 7, 8, 9, 14, 15, 16, 17 als Funktionen, in Form einer Matrix oder auf jede andere, im Stand der Technik bekannte Art gespeichert sein. Es versteht sich ferner, daß das Rechnerprogramm Zwischenwerte ermitteln kann, die in der Grafik gemäß Figur 4 eingezeichnete Kurvenschar keine der zuvor ermittelten Tiefe d entsprechende Gerade oder wenn die in der Grafik gemäß Figur 5 eingezeichnete Kurvenschar keine der Masse 5 entsprechende Kurve enthält.

## Patentansprüche

1. Verfahren zur Ermittlung von ferromagnetischen Verunreinigungen (5) in Werkstücken (1) aus unmagnetischem Material durch Magnetisierung der Verunreinigung (5) und durch Messung des magnetischen Signals der Verunreinigung (5) mittels eines Magnetfeldmeßgeräts (3), **gekennzeichnet durch** folgende Verfahrensschritte:
a) Das Werkstück (1) wird zumindest abschnittsweise im wesentlichen gleichmäßig über das Volumen einem Magnetfeld ausgesetzt;
b) das Werkstück (1) wird erst dann dem Magnetfeldmeßgerät (3) zugeführt und dort das magnetische Signal der jeweiligen Verunreinigung (5) erfaßt;
c) die Tiefe der jeweiligen Verunreinigung (5) im Werkstück (1) wird **durch** folgende Maßnahmen festgestellt:
aa) Erfassen des Signal der Verunreinigung (5) in einem ersten Abstand zwischen Magnetfeldfühler (3) und der Oberfläche des Werkstücks (1);
bb) Erfassen des Signals der Verunreinigung (5) in einem zweiten Abstand zwischen Magnetfeldfühler (3) und Oberfläche des Werkstücks (1);
cc) Bildung eines Signalverhältnisses als Quotient der Meßsignale aus den beiden erfaßten Signalen der Verunreinigung (5);
dd) Feststellung der Tiefe (d) anhand einer Kurve (6), die die Abhängigkeit zwischen Signalverhältnis und Tiefe darstellt.

2. Verfahren nach Anspruch 1, **dadurch gekennzeichnet, daß** die Verunreinigungen (5) bis zur Sättigung durchmagnetisiert werden.

3. verfahren nach Anspruch 1 oder 2, **dadurch gekennzeichnet, daß** das Werkstück (1) einem weitgehend homogenen Magnetfeld ausgesetzt wird.

4. Verfahren nach einem der Ansprüche 1 bis 3, **dadurch gekennzeichnet, daß** das Werkstück vor der Magnetisierung einer Entmagnetisierung unterworfen wird.

5. Verfahren nach einem der Ansprüche 1 bis 4, **dadurch gekennzeichnet, daß** das Werkstück (1) in einer Abtastebene (4) mit dem Magnetfeldmeßgerät abgetastet und auf diese Weise die Lage der Verunreinigung (5) in Bezug auf diese Abtastebene (4) festgestellt wird.

6. Verfahren nach einem der Ansprüche 1 bis 5, **dadurch gekennzeichnet, daß** die Masse (e) der Verunreinigung (5) durch folgende zusätzliche Maßnahmen festgestellt wird:
a) Auswahl einer der festgestellten Tiefe (d) entsprechenden Kurve (9, 13) aus einer Kurvenschar, die den Zusammenhang zwischen Masse und Meßsignal bei verschiedenen Tiefen darstellt;
b) Feststellung der Masse (e) anhand des Meßsignals und der ausgewählten Kurve (9).

7. Verfahren nach Anspruch 6, **dadurch gekennzeichnet, daß** die Masse (e) der Verunreinigung (5) mit Hilfe einer Kurve (15) aus einer Kurvenschar bestimmt wird, die den Zusammenhang zwischen Tiefe und Meßsignal bei verschiedenen Massen darstellt, und zwar anhand des Meßsignals und der festgestellten Tiefe.

8. Verfahren nach einem der Ansprüche 1 bis 7, **dadurch gekennzeichnet, daß** als Magnetfeldmeßgerät (3) ein Gradiometer 2. Ordnung mit supraleitenden Quanten-Interferometern, SQUID, auf der Basis von Hochtemperatur-Supraleitern verwendet wird.

9. Magnetfeldmeßgerät insbesondere zur Durchführung des Verfahrens nach einem der Ansprüche 1 bis 8, mit einem Magnetfeldfühler (3), **gekennzeichnet durch** folgende Merkmale:
a) der Magnetfeldfühler (3) ist in einer Abtastebene (4) bewegbar;
b) der Magnetfeldfühler (3) ist senkrecht zur Abtastebene (4) zwischen zwei Meßpositionen bewegbar;
c) das Magnetfeldmeßgerät weist eine Einrichtung zur Errechnung des Signalverhältnisses der Meßsignale in den beiden Meßpositionen auf;
d) in dem Magnetfeldmeßgerät ist eine Kurve gespeichert, die die Abhängigkeit zwischen dem Signalverhältnis und der Tiefe (d) der Verunreinigung (5) im Werkstück (1) darstellt;
e) das Magnetfeldmeßgerät weist eine Einrichtung zur Errechnung der Tiefe einer Verunreinigung (5) anhand des festgestellten Signalverhältnisses und der Kurve auf.

10. Magnetfeldmeßgerät nach Anspruch 9, **gekennzeichnet durch** folgende weitere Merkmale:
a) in dem Magnetfeldmeßgerät ist eine Kurvenschar von Kurven für verschiedene Tiefen gespeichert, die die Abhängigkeit zwischen Masse der Verunreinigung (5) und Meßsignal bei verschiedenen Tiefen darstellen;
b) das Magnetfeldmeßgerät weist eine Einrichtung zur Errechnung der Masse (e) der Verunreinigung (5) anhand der Kurvenschar **durch** Auswahl der der festgestellten Tiefe (d) entsprechenden Kurve (9) und anhand des Meßsignals auf.

11. Magnetfeldmeßgerät nach Anspruch 9, **gekennzeichnet durch** folgende weitere Merkmale:
a) in dem Magnetfeldmeßgerät ist eine Kurvenschar von Kurven (14, 15, 16, 17) für verschiedene Massen von Verunreinigungen (5) gespeichert, die die Abhängigkeit zwischen Tiefe und Meßsignal bei verschiedenen Massen darstellt;
b) das Magnetfeldmeßgerät weist eine Einrichtung zur Errechnung der Masse (e) der Verunreinigung (5) anhand des Meßsignals und der festgestellten Tiefe (d) auf.

12. Magnetfeldmeßgerät nach einem der Ansprüche 9 bis 11, **dadurch gekennzeichnet, daß** das Magnetfeldmeßgerät ein Gradiometer 2. Ordnung mit supraleitenden Quanten-Interferometern, SQUID, auf der Basis von Hochtemperatur-Supraleitern ist.

## Claims

1. Method for the detection of ferromagnetic impurities (5) in workpieces (1) made of non-magnetic material by magnetization of the impurity (5) and measurement of the magnetic signal from the impurity (5) using a magnetic field measuring instrument (3), **characterized by** the following process steps:
a) The workpiece (1) is exposed to a magnetic field at least sectionally and essentially uniformly over the volume.
b) The workpiece (1) is thereafter presented to the magnetic field measuring instrument (3) for detecting the magnetic signal from the respective impurity (5).
c) The depth position of the respective impurity (5) in the workpiece (1) is determined by the following procedure:
aa) Recording of the signal from the impurity (5) at a first distance between the magnetic field detector (3) and the surface of the workpiece (1).
bb) Recording of the signal from the impurity (5) at a second distance between the magnetic field detector (3) and the surface of the workpiece (1).
cc) Formation of a signal ratio as quotient of the measuring signals of the two detected signals from the impurity (5).
dd) Determination of the depth position (d) by means of a curve (6) representing the relation between signal ratio and depth position.

2. Method in accordance with Claim 1, **characterized in that** impurities (5) are magnetized to saturation.

3. Method in accordance with Claim 1 or 2, **characterized in that** the workpiece (1) is exposed to a widely homogenous magnetic field.

4. Method in accordance with one of the Claims 1 to 3, **characterized in that** the workpiece is subjected to demagnetization prior to magnetization.

5. Method in accordance with one of the Claims 1 to 4, **characterized in that** the workpiece (1) is scanned in a scanning plane (4) by means of the magnetic field measuring instrument, thus determining the position of the impurity (5) relative to the scanning plane (4).

6. Method in accordance with one of the Claims 1 to 5, **characterized in that** the mass (e) of the impurity (5) is determined by the following additional measures:
a) Selection of a curve (9, 13) from a set of curves, which corresponds to the established depth (d) and represents the relation between mass and measuring signal at various depths;
b) Determination of the mass (e) using the measuring signal and the selected curve (9).

7. Method in accordance with Claim 6, **characterized in that** the mass (e) of the impurity (5) is determined by means of a curve (15) from a set of curves, which represents the relation between depth and measuring signal at various masses, using the measuring signal and the depth established.

8. Method in accordance with one of the Claims 1 to 7, **characterized in that** a 2^{nd} order gradiometer with superconducting quantum interferometers, SQUID, on the basis of high-temperature superconductors is used as magnetic field measuring instrument (3).

9. Magnetic field measuring instrument, especially for performing the method in accordance with one of the Claims 1 to 8, provided with a magnetic field detector (3), **characterized by** the following features:
a) The magnetic field detector (3) is moveable in one scanning plane (4).
b) The magnetic field detector (3) is moveable vertical to the scanning plane (4) between two measuring positions.
c) The magnetic field measuring instrument is provided with a device for calculating the ratio of the measuring signals at the two measuring points.
d) A curve is stored in the magnetic field measuring instrument representing the relation between the signal ratio and the depth (d) of the impurity (5) in the workpiece (1).
e) The magnetic field measuring instrument is provided with a device for calculating the depth of an impurity (5) by means of the signal ratio determined and the curve.

10. Magnetic field measuring instrument in accordance with Claim 9, **characterized by** the following additional features:
a) A set of curves for various depths is stored in the magnetic field measuring instrument representing the relation between the mass of the impurity (5) and the measuring signal at various depths.
b) The magnetic field measuring instrument is provided with a device for calculating the mass (e) of the impurity (5) using the set of curves, by selection of the curve (9) corresponding to the depth (d) determined, and the measuring signal.

11. Magnetic field measuring instrument in accordance with Claim 9, **characterized by** the following additional features:
a) A set of curves (14, 15, 16, 17) for various masses of impurities (5) is stored in the magnetic field measuring instrument representing the relation between depth and measuring signal at various masses.
b) The magnetic field measuring instrument is provided with a device for calculating the mass (e) of the impurity (5) by means of the measuring signal and the depth (d) determined.

12. Magnetic field measuring instrument in accordance with one of the Claims 9 to 11, **characterized in that** the magnetic field measuring instrument is a 2^{nd} order gradiometer with superconducting quantum interferometers, SQUID, on the basis of high-temperature superconductors.

## Revendications

1. Procédé destiné à détecter des impuretés (5) ferromagnétiques dans des pièces d'oeuvre (1) en matériau amagnétique par aimantation de l'impureté (5) et mesure du signal magnétique issu de l'impureté (5) au moyen d'un mesureur de champ magnétique (3), **caractérisé par** les opérations suivantes:
a) La pièce d'oeuvre (1) est exposée, du moins en partie, à un champ magnétique pour l'essentiel réparti régulièrement sur le volume.
b) La pièce d'oeuvre (1) est ensuite introduite dans le mesureur de champ magnétique (3) où le signal magnétique de chaque impureté (5) est capté.
c) La profondeur de chaque impureté (5) dans la pièce d'oeuvre (1) est déterminée par les opérations suivantes :
aa) Captage du signal de l'impureté (5) à une première distance entre le capteur de champ magnétique (3) et la surface de la pièce d'oeuvre (1).
bb) Captage du signal de l'impureté (5) à une seconde distance entre le capteur de champ magnétique (3) et la surface de la pièce d'oeuvre (1).
cc) Formation d'un rapport de signal comme quotient des signaux de mesure issus des deux signaux captés de l'impureté (5).
dd) Détermination de la profondeur (d) à l'aide d'une courbe (6) représentant la relation entre le rapport de signal et la profondeur.

2. Procédé selon la revendication n° 1, **caractérisé en ce que** les impuretés (5) sont aimantées entièrement jusqu'à saturation.

3. Procédé selon la revendication n° 1 ou 2, **caractérisé en ce que** la pièce d'oeuvre (1) est exposée à un champ magnétique largement homogène.

4. Procédé selon une des revendications n° 1 à 3, **caractérisé en ce que** la pièce d'oeuvre est soumise à une désaimantation avant l'aimantation.

5. Procédé selon une des revendications n° 1 à 4, **caractérisé en ce que** la pièce d'oeuvre (1) est explorée avec le mesureur de champ magnétique dans un plan d'exploration (4), et que de ce cette manière la position de l'impureté (5) par rapport à ce plan d'exploration (4) est déterminée.

6. Procédé selon une des revendications n° 1 à 5, **caractérisé en ce que** la masse (e) de l'impureté (5) est déterminée par les mesures suivantes supplémentaires:
a) Sélection d'une courbe (9, 13) dans une famille de courbes, qui correspond à la profondeur (d) déterminée et qui représente la relation entre la masse et le signal de mesure à différentes profondeurs.
b) Relevé de la masse (e) à l'aide du signal de mesure et de la courbe (9) sélectionnée.

7. Procédé selon la revendication n° 6, **caractérisé en ce que** la masse (e) de l'impureté (5) est déterminée à l'aide d'une courbe (15) sélectionnée dans une famille de courbes, qui représente pour différentes masses la relation entre la profondeur et le signal de mesure, moyennant le signal de mesure et la profondeur déterminée.

8. Procédé selon une des revendications n° 1 à 7, **caractérisé en ce qu'**un gradiomètre de 2ème ordre avec interféromètres quantiques supraconducteurs, SQUID, sur la base de supraconducteurs haute température est utilisé en tant que mesureur de champ magnétique (3).

9. Mesureur de champ magnétique, en particulier destiné à réaliser le procédé selon une des revendications n° 1 à 8, pourvu d'un capteur de champ magnétique (3) et présentant les caractéristiques suivantes:
a) Le capteur de champ magnétique (3) peut être déplacé dans un plan d'exploration (4).
b) Le capteur de champ magnétique (3) peut être déplacé perpendiculairement au plan d'exploration (4) entre deux positions de mesure.
c) Le mesureur de champ magnétique présente un dispositif pour calculer le rapport de signal des signaux de mesure aux deux positions de mesure.
d) Dans le mesureur de champ magnétique est enregistrée une courbe qui représente la relation entre le rapport de signal et la profondeur (d) de l'impureté (5) dans la pièce d'oeuvre (1).
e) Le mesureur de champ magnétique présente un dispositif pour calculer la profondeur d'une impureté (5) à l'aide du rapport de signal déterminé et de la courbe.

10. Mesureur de champ magnétique selon la revendication n° 9, présentant les caractéristiques suivantes supplémentaires:
a) Dans le mesureur de champ magnétique est enregistrée une famille de courbes pour différentes profondeurs, qui représentent la relation entre la masse de l'impureté (5) et le signal de mesure à différentes profondeurs.
b) Le mesureur de champ magnétique présente un dispositif pour calculer la masse (e) de l'impureté (5) à l'aide de la famille de courbes, en sélectionnant la courbe (9) correspondant à la profondeur (d) déterminée, et à l'aide du signal de mesure.

11. Mesureur de champ magnétique selon la revendication n° 9, présentant les caractéristiques suivantes supplémentaires:
a) Dans le mesureur de champ magnétique est enregistrée une famille de courbes (14, 15, 16, 17) pour différentes masses d'impuretés (5), qui représentent la relation entre la profondeur et le signal de mesure à différentes masses.
b) Le mesureur de champ magnétique présente un dispositif pour calculer la masse (e) de l'impureté (5) à l'aide du signal de mesure et de la profondeur (d) déterminée.

12. Mesureur de champ magnétique selon une des revendications n° 9 à 11, **caractérisé en ce que** le mesureur de champ magnétique est constitué par un gradiomètre de 2ème ordre avec interféromètres quantiques supraconducteurs, SQUID, sur la base de supraconducteurs haute température.
